Europäisches Patentamt

European Patent Office

Office européen des brevets

(11) Veröffentlichungsnummer: **0 204 177**

**A1**

(12) **EUROPÄISCHE PATENTANMELDUNG**

(21) Anmeldenummer: **86106435.0**

(22) Anmeldetag: **12.05.86**

(51) Int. Cl.⁴: **H01L 23/50** , H01L 23/48

(30) Priorität: **31.05.85 DE 3519571**

(43) Veröffentlichungstag der Anmeldung:
**10.12.86 Patentblatt 86/50**

(84) Benannte Vertragsstaaten:
**AT DE FR GB IT NL**

(71) Anmelder: **Siemens Aktiengesellschaft Berlin und München**
**Wittelsbacherplatz 2**
**D-8000 München 2(DE)**

(72) Erfinder: **Kantz, Dieter, Dipl.-Ing.**
**Heiglhofstrasse 45**
**D-8000 München 70(DE)**

(54) **Anschlussanordnung für einen integrierten Halbleiterschaltkreis.**

(57) Es wird ein integrierter Halbleiterschaltkreis vorgestellt mit Anschlußflächen (1 bis 18) auf an Stirnflächen eines Halbleiterchips angrenzenden Bereichen (S) für den elektrischen Anschluß von elektrischen Signalen und/oder Potentialen. Für den elektrischen Anschluß einiger dieser elektrischen Signale und/oder Potentiale sind innerhalb eines Rasterfeldes (R), das elektrische Schaltungen (SF, PS) und mindestens einen von den elektrischen Scahltungen (SF, PS) freien Flächenbereich (F) aufweist, im freien Flächenbereich (F) zwischen den Bereichen (S) weitere Anschlußflächen (4a, 5a, 13a, 14a) vorgesehen. Je nach zu verwendendem Gehäuse für den integrierten Halbleiterschaltkreis werden für die betroffenen Signale und/oder Potentiale bei der Kontaktierung entweder die üblichen Anschlußflächen - (4, 5, 13, 14) oder die weiteren Anschlußflächen (4a, 5a, 13a, 14a) verwendet.

FIG 1

EP 0 204 177 A1

## Anschlußanordnung für einen integrierten Halbleiterschaltkreis

Die Erfindung betrifft eine Anschlußanordnung für einen integrierten Halbleiterschaltkreis gemäß dem Oberbegriff des Patentanspruches 1.

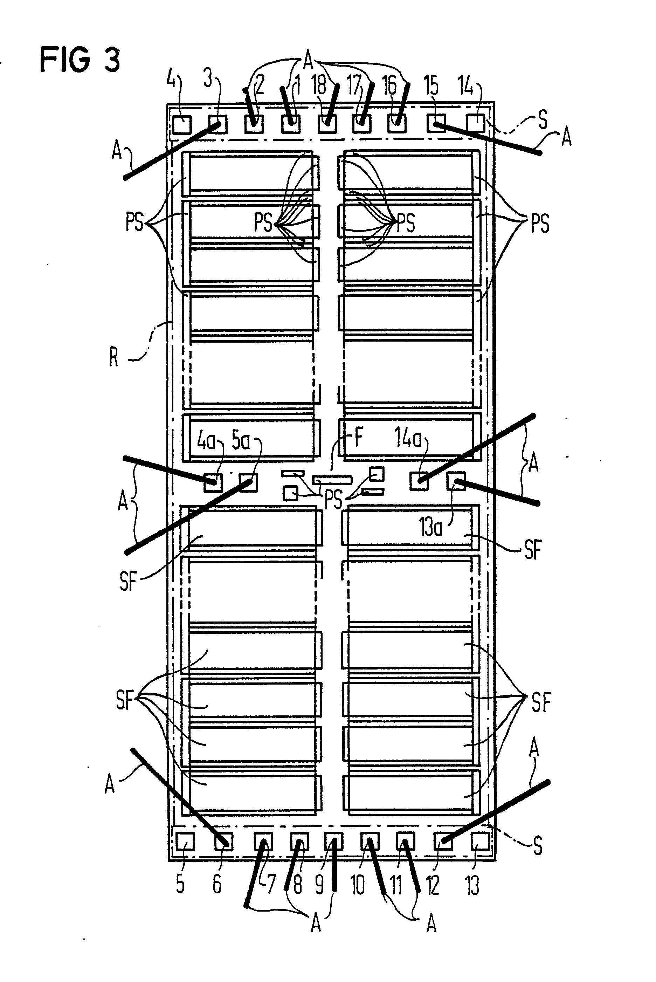

Moderne integrierte Halbleiterschaltkreise werden immer komplexer und benötigen trotz steigender Integrationsdichte zunehmend mehr Chipfläche. Um Chipfläche zu sparen, ist es aus IEEE International Solid-State Circuits Conference 1985, Seiten 256 bis 257, insbesondere Figur 3 auf Seite 360 bekannt, auf Halbleiterchips der Halbleiterschaltkreise Anschlußflächen für einen elektrischen Anschluß an einzelne elektrische Signale und/oder Potentiale mittels Anschlußleitungen nur auf an Stirnflächen angrenzenden Bereichen einer Oberfläche der Halbleiterchips vorzusehen. Damit läßt sich in der Breite des Halbleiterchips Chipfläche sparen. Diese Art der Anschlußanordnung läßt sich ohne Schwierigkeiten bei der Montage des Halbleiterchips jedoch nur dann anwenden, wenn für den integrierten Halbleiterschaltkreis ein Keramikgehäuse verwendet wird.

Bei integrierten Halbleiterschaltkreisen mit Plastikgehäuse ist dies nur bedingt möglich. Für den elektrischen Anschluß mittels Anschlußleitungen in Plastikgehäuse wird nämlich im allgemeinen eine sogenannte Spinne verwendet, die Anschlußflächen an allen Seiten der Oberfläche des Halbleiterchips voraussetzt. Demgemäß werden also Halbleiterchips für Montage in Plastikgehäuse verwendet, die Anschlußflächen an allen Seiten der Oberfläche des Halbleiterchips aufweisen. Die dazu benötigte Chipfläche ist jedoch größer als bei einem Halbleiterchip der oben genannten Art für Keramikmontage. Dies wirkt sich insbesondere in der benötigten Chipbreite aus, was dazu führen kann, daß zur Montage des Halbleiterchips unter Umständen ein Gehäuse verwendet werden muß, das breiter ist als ein ursprünglich vorgesehenes Gehäuse. Eine entsprechende Anschlußanordnung zeigt Fig. 6, Seite 361 von "IEEE International Solic-State Circuits Conference 1985", Seiten 260 bis 261.

Einen Kompromiß zwischen den oben genannten unterschiedlichen Anforderungen an die Anordnung von Anschlußflächen bezüglich der beiden Gehäusearten zeigt die Veröffentlichung "IEEE International Solid-State Circuits Conference 1985", Seiten 244 bis 245, insbesondere Fig. 6, Seite 355. Die Anschlußflächen befinden sich dabei auf an die Stirnflächen des Halbleiterchips angrenzenden Bereichen seiner Oberfläche, auf einer, von einer Chipecke aus beginnend, Hälfte einer ersten Längsfläche und, diagonal dieser gegenüberliegend, ebenfalls einer Hälfte einer zweiten Längsfläche. Zwei Hälften eines Rasterfeldes mit elektrischen Schaltungen sind dabei seitlich gegeneinander versetzt. Mit dieser Anordnung ist es möglich, die Chipbreite, die ja gleich ist der Länge einer Stirnfläche, gegenüber einem sonst üblichen Halbleiterschaltkreis-Design für Montage im Plastikgehäuse um den Platzbedarf der Breite einer Reihe von Anschlußflächen zu vermindern und trotzdem die Montage im Plastikgehäuse zu ermöglichen. Bei dieser Anordnung ist jedoch die Chipbreite immer noch größer als bei der vorstehend für Montage in einem Keramikgehäuse beschriebenen Anschlußanordnung.

Aufgabe der vorliegenden Erfindung ist es, eine Anschlußanordnung für einen integrierten Halbleiterschaltkreis der eingangs genannten Art zu schaffen, die bei einem minimalen Bedarf an Chipfläche und Chipbreite für beide Montagetechniken geeignet ist.

Diese Aufgabe wird erfindungsgemäß gelöst durch den kennzeichnenden Teil des Patentanspruches 1.

Vorteilhafte Aus-und Weiterbildungen sind in Unteransprüchen gekennzeichnet.

Durch die erfindungsgemäße Anordnung ist es bei einem Bedarf an Chipfläche und Chipbreite für den Halbleiterchip eines eingangs beschriebenen Halbleiterschaltkreises für Keramikgehäuse möglich, auch Plastikgehäuse zu verwenden. Die Erfindung läßt sich auf alle bekannten integrierten Halbleiterschaltkreise anwenden. Sie ist besonders geeignet für Halbleiterschaltkreise mit vielen regelmäßigen Strukturen, wie sie insbesondere Mikroprozessoren und integrierte Halbleiterspeicher aufweisen.

Im folgenden wird die Erfindung anhand der Figuren 1 -4 erläutert. Es zeigen dabei:

Fig. 1 einen Ausschnitt aus einem Halbleiterchip mit einer erfindungsgemäßen Anschlußanordnung,

Fig. 2 den Halbleiterchip gemäß Fig. 1, kontaktiert für ein Keramikgehäuse,

Fig. 3 den Halbleiterchip gemäß Fig. 1, kontaktiert für ein Plastikgehäuse,

Fig. 4 eine Weiterbildung der Erfindung.

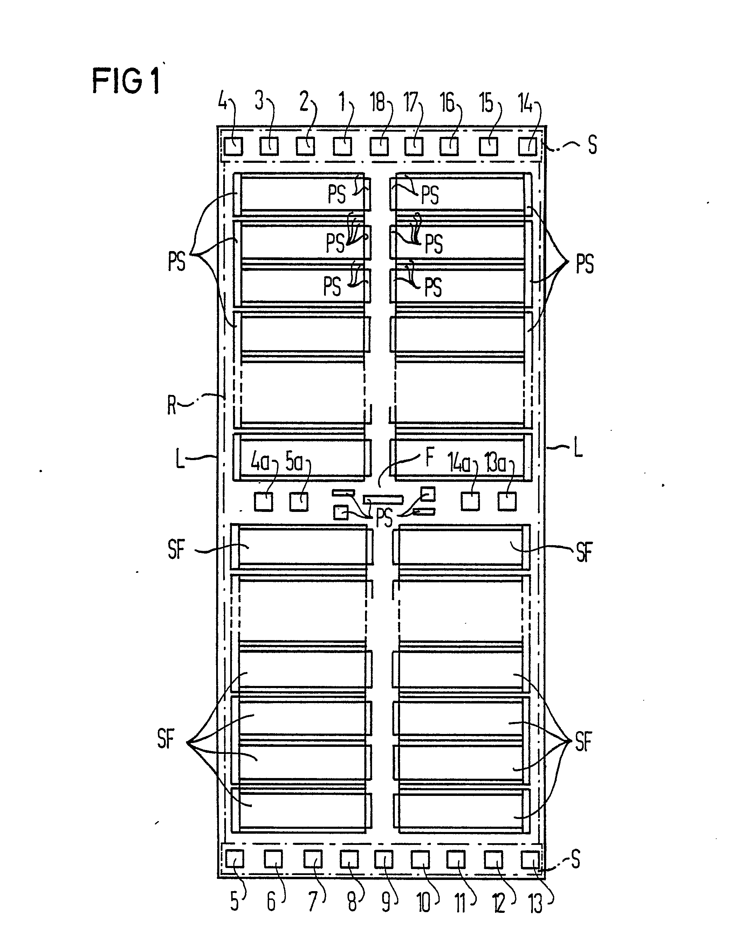

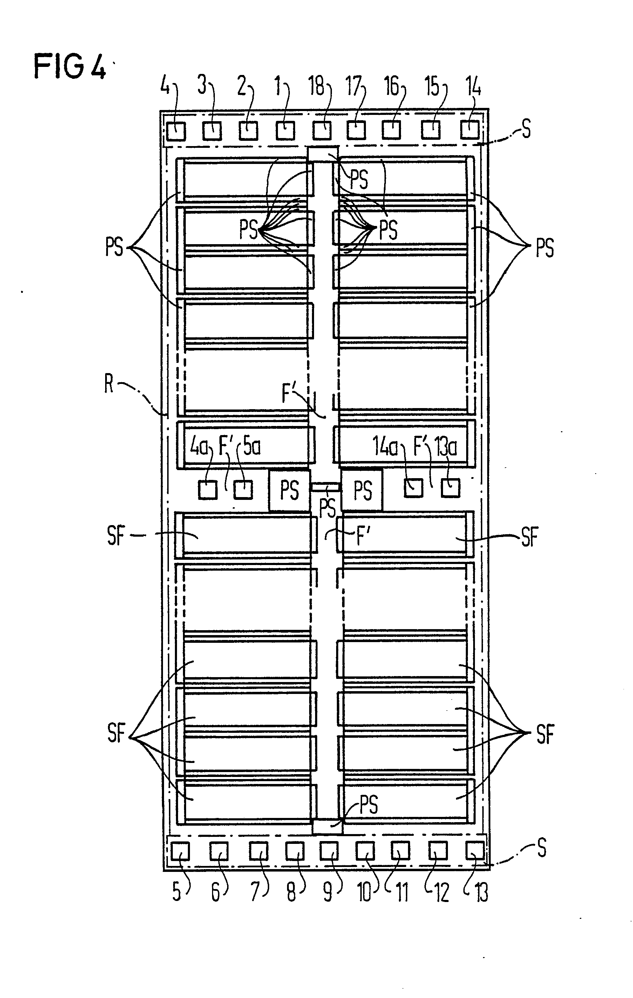

In Fig. 1 ist ausschnittweise die Draufsicht auf einen Halbleiterchip mit einer Anschlußanordnung gemäß der Erfindung dargestellt. Um eine genügend große Übersicht zu erhalten, wurde ein Halbleiterspeicher mit vielen, sich meist regelmäßig wiederholenden elektrischen Schaltungen SF, PS und mit einem von den Schaltungen freien Flächenbereich F gewählt. Die mit SF bezeichneten Schaltungen stellen dabei jeweils ein Speicherfeld dar. Die mit PS bezeichneten Schaltungen stellen sogenannte Peripherieschaltungen dar, wie zum Beispiel Adreßdecoder, Leseverstärker und ähnliches. Die elektrischen Schaltungen SF, PS und der freie Flächenbereich F bilden zusammen ein Rasterfeld R. Das Rasterfeld R kann erfindungsgemäß auch anstelle eines Flächenbereiches F mehrere Flächenbereiche F' aufweisen. Diese Flächenbereiche F' können gemäß Fig. 4 in vorteilhafter Weise durch einen Teil der elektrischen Schaltungen SF, PS geometrisch voneinander getrennt sein. Der Halbleiterchip selbst weist außer dem Rasterfeld R zwei an Stirnflächen angrenzende, relativ schmale Bereiche S einer seiner Oberflächen und zwei gegenüber der Länge der Stirnflächen relativ lange Längsseiten L als seitlichen Rand auf. Das Rasterfeld R reicht dabei seitlich bis fast an den seitlichen Rand des Halbleiterchips heran. Aus Gründen der Platzersparnis weist der Halbleiterchip an den Längsseiten L keinerlei Anschlußflächen auf. Sämtliche elektrisch notwendige Anschlußflächen (1 bis 18) des Halbleiterchips sind auf den an die Stirnflächen angrenzenden Bereichen S angeordnet. Insofern entspricht der dargestellt Halbleiterchip einem Halbleiterchip gemäß dem Stand der Technik für Keramikmontage. Erfindungsgemäß weist der Halbleiterchip jedoch zusätzlich zu den elektrisch notwendigen Anschlußflächen 1 bis 18 innerhalb des Rasterfeldes R im Flächenbereich F weitere Anschlußflächen 4a, 5a, 13a, 14a auf. Die weiteren Anschlußflächen 4a, 5a, 13a und 14a können erfindungsgemäß auch in mehreren Flächenbereichen F' angeordnet sein. Ebenso können die Flächenbereiche F' mit den weiteren Anschlußflächen 4a, 5a, 13a, 14a in vorteilhafter Weise durch einen Teil der elektrischen Schaltungen SF, PS geometrisch voneinander getrennt sein (vgl. Fig. 4). Dadurch, daß diese weiteren Anschlußflächen 4a, 5a, 13a, 14a, die ebenfalls dem elektrischen Anschluß von wenigstens einigen der elektrischen Signale und/oder Potentiale des Halbleiterchips dienen, sich innerhalb des Rasterfeldes R befinden und dadurch, daß die Geometrie des Rasterfeldes R mindestens in ihrer Breite unabhängig von den weiteren Anschlußflächen 4a, 5a, 13a und 14a ist, wird für diese weiteren Anschlußflächen 4a, 5a, 13a, 14a keinerlei zusätzliche Fläche auf dem Halbleiterchip benötigt. Der Halbleiterchip weist insbesondere auch eine minimale Breite auf, die im wesentlichen gleich der Breite des Rasterfeldes R ist.

Es ist weiterhin vorteilhaft, daß die weiteren Anschlußflächen 4a, 5a, 13a, 14a Anschlußflächen solcher Signale und/oder Potentiale sind, deren Leiterbahnführung innerhalb des Rasterfeldes R unabhängig von einem Vorhandensein der weiteren Anschlußflächen 4a, 5a, 13a, 14a bereits den freien Flächenbereich F benützt. Damit ist es möglich, ohne zusätzlichen Flächen-und Leiterbahnaufwand die weiteren Anschlußflächen 4a, 5a, 13a, 14a erfindungsgemäß im freien Flächenbereich F anzuordnen.

Es ist ebenfalls vorteilhaft, daß die weiteren Anschlußflächen 4a, 5a, 13a und 14a Anschlußflächen solcher Signale und/oder Potentiale sind, deren auf den an die Stirnflächen angrenzenden Bereichen S angeordnete Anschlußflächen 4, 5, 13 und 14 in der Nähe von Chipecken plaziert sind. Damit wird nämlich bei einem elektrischen Anschluß mittels Anschlußleitung A innerhalb eines Plastikgehäuses zur Herstellung des integrierten Schaltkreises, wie in Fig. 3 gezeigt, eine Anschlußführung über das Rasterfeld R weitestgehend vermieden. Daraus resultiert dann auch eine Verringerung der Gefahr eines elektrischen Kurzschlusses zwischen den Anschußleitungen A und den elektrischen Schaltungen SF, PS des Rasterfeldes R.

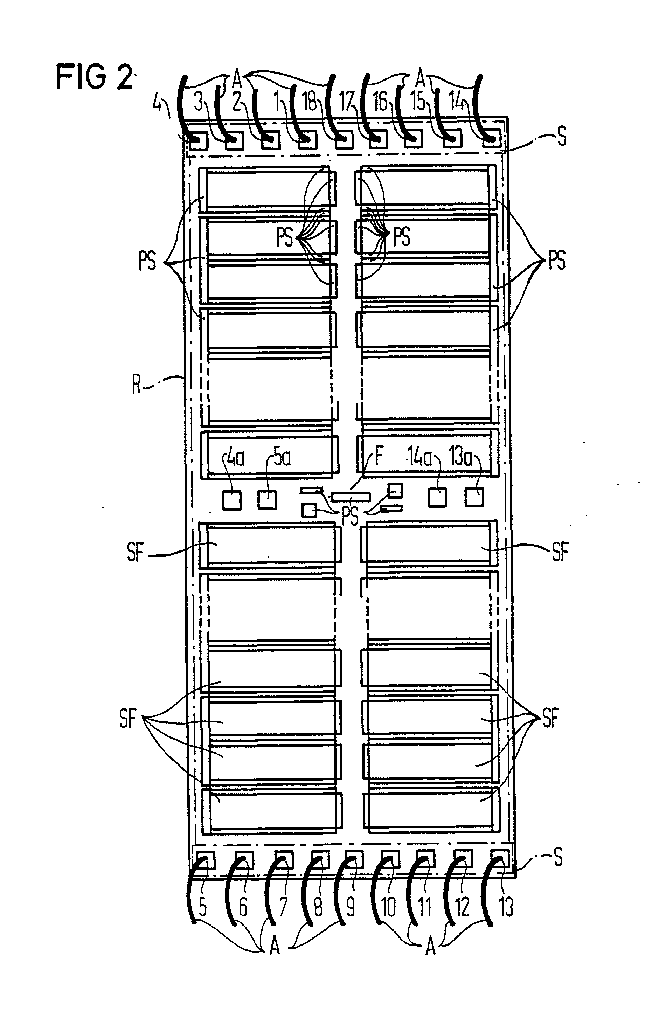

Für den elektrischen Anschluß mittels Anschlußleitungen A innerhalb eines Keramikgehäuses zur Herstellung des integrierten Schaltkreises dienen die Anschlußflächen 1 bis 18. Die weiteren Anschlußflächen 4a, 5a, 13a, 14a bleiben unbenützt und unbeschaltet. Ein solchermaßen verdrahteter Schaltkreis ist in Fig. 2 dargestellt. Für den elektrischen Anschluß mittels Anschlußleitungen A innerhalb eines Plastikgehäuses zur Herstellung des integrierten Schaltkreises dienen die Anschlußflächen 1, 2, 3, 6 bis 12, 15 bis 18 sowie die weiteren Anschlußflächen 4a, 5a, 13a und 14a. Die Anschlußflächen 4, 5, 13 und 14 bleiben unbenützt. Ein solchermaßen verdrahteter Schaltkreis ist in Fig. 3 dargestellt.

Bei beiden vorgenannten Anschlußmöglichkeiten können die jeweils unbenützten Anschlußflächen (4a, 5a, 13a, 14a beziehungsweise 4, 5, 13, 14) gegenüber ihrem Zustand nach der Herstellung des Halbleiterchips unverändert bleiben. Sie müssen im allgemeinen weder mit irgendwelchen Abschlußwiderständen versehen werden noch müssen ihre zugehörigen Leiterbahnen unterbrochen werden.

**Ansprüche**

1. Anschlußanordnung für einen integrierten Halbleiterschaltkreis mit mehreren Anschlußflächen (1 bis 18) zum elektrischen Anschluß des Halbleiterschaltkreises an elektrische Signale und/oder Potentiale, wobei sich die Anschlußflächen (1 bis 18) auf an Stirnflächen angrenzender Bereiche (S) einer Oberfläche eines im Halbleiterschaltkreis enthaltenen Halbleiterchips befinden, mit elektrischen Schaltungen (SF, PS), die sich auf dem beziehungsweise im Halbleiterchip befinden, wobei die elektrischen Schaltungen (SF, PS) innerhalb eines Rasterfeldes (R) so angeordnet sind, daß innerhalb dieses Rasterfeldes (R) mindestens ein Flächenbereich (F) frei von den Schaltungen (SF, PS) ist, **dadurch gekennzeichnet, daß** für den elektrischen Anschluß von wenigstens einigen der elektrischen Signale und/oder Potentiale zusätzlich zu den dafür vorgesehenen Anschlußflächen (4, 5, 13, 14) auf den an die Stirnflächen angrenzenden Bereichen (S) zwischen diesen Bereichen (S) innerhalb des von den Schaltungen (SF, PS) freien Flächenbereiches (F) des Rasterfeldes (R) weitere Anschlußflächen (4a, 5a, 13a, 14a) des Halbleiterchips angeordnet sind.

2. Anschlußanordnung nach Anspruch 1, **dadurch gekennzeichnet, daß** die elektrischen Signale und/oder Potentiale, für die die weiteren Anschlußflächen (4a, 5a, 13a, 14a) zwischen den an die Stirnflächen angrenzenden Bereichen (S) des Halbleiterchips vorhanden sind, wahlweise an den ihnen jeweils entsprechenden Anschlußflächen (4, 5, 13, 14) auf den Bereichen (S) oder an den weiteren Anschlußflächen (4a, 5a, 13a, 14a) zwischen den Bereichen (S) des Halbleiterchips elektrisch anschließbar sind.

3. Anschlußanordnung nach Anspruch 1 oder 2, **dadurch gekennzeichnet, daß** der Halbleiterchip innerhalb des Rasterfeldes (R) mehrere Flächenbereiche (F') aufweist, in denen die weiteren Anschlußflächen (4a, 5a, 13a, 14a) angeordnet sind.

4. Anschlußanordnung nach Anspruch 3, **dadurch gekennzeichnet, daß** die Flächenbereiche (F') mit den weiteren Anschlußflächen (4a, 5a, 13a, 14a) durch einen Teil der elektrischen Schaltungen (SF, PS) geometrisch voneinander getrennt sind.

5. Anschlußanordnung nach einem der vorhergehenden Ansprüche, **dadurch gekennzeichnet, daß** die weiteren Anschlußflächen (4a, 5a, 13a, 14a) Anschlußflächen von solchen elektrischen Signalen und/oder Potentialen sind, deren Leiterbahnführung innerhalb des Rasterfeldes (R) unabhängig vom Vorhandensein der weiteren Anschlußflächen (4a, 5a, 13a, 14a) den freien Flächenbereich (F; F') benützt.

6. Anschlußanordnung nach einem der vorhergehenden Ansprüche, **dadurch gekennzeichnet, daß** die weiteren Anschlußflächen (4a, 5a, 13a, 14a) Anschlußflächen solcher Signale und/oder Potentiale sind, deren auf den an die Stirnflächen angrenzenden Bereichen (S) angeordnete Anschlußflächen (4, 5, 13, 14) in der Nähe von Ecken des Halbleiterchips plaziert sind.

FIG 1

FIG 2

FIG 3

FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | IEEE INTERNATIONAL SOLID-STATE CIRCUITS CONFERENCE, 10. Februar 1982, Seiten 68-69; B. FITZGERALD et al.: "A 288Kb dynamic RAM" * Seiten 68-69; Figur 2 * | 1 | H 01 L 23/50 H 01 L 23/48 |
| A | GB-A-2 061 617 (HITACHI) * Figur 2; Seite 3, Zeilen 49-58 * | 1 | |
| A | EP-A-0 127 100 (KABUSHIKI KAISHA TOSHIBA) * Figur 5; Seite 6, Zeile 36 - Seite 7, Zeile 22 * | 1 | |
| A | IEEE INTERNATIONAL ELECTRON DEVICES MEETING, 7.-9. Dezember 1981, Washington, D.C., Seiten 62-65, IEEE, New York, US; K. MUKAI et al.: "A new integration technology that enables forming bonding pads on active areas" * Seiten 62-65; Figur 8 * | 1 | RECHERCHIERTE SACHGEBIETE (Int. Cl.4) H 01 L |
| A | PATENTS ABSTRACTS OF JAPAN, Band 7, Nr. 229(E-203) 1374, 12. Oktober 1983; & JP - A - 58 119 648 (MITSUBISHI DENKI K.K.) 16.07.1983 * Zusammenfassung * | 1 | |

-----

Der vorliegende Recherchenbericht wurde für alle Patentansprüche erstellt.

| Recherchenort | Abschlußdatum der Recherche | Prüfer |
|---|---|---|
| DEN HAAG | 05-09-1986 | CAMPLING N.C.G. |